(19)

Europäisches Patentamt

European Patent Office

Office européen des brevets

(11) **EP 4 654 245 A1**

(12) **EUROPEAN PATENT APPLICATION**

(43) Date of publication:
**26.11.2025** Bulletin 2025/48

(21) Application number: **25175370.3**

(22) Date of filing: **09.05.2025**

(51) International Patent Classification (IPC):
**H01J 37/304** (2006.01)   **H01J 37/317** (2006.01)

(52) Cooperative Patent Classification (CPC):
**H01J 37/3045; H01J 37/3177;** H01J 2237/20292

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.05.2024 EP 24175161**

(71) Applicant: **IMS Nanofabrication GmbH**
**2345 Brunn am Gebirge (AT)**

(72) Inventors:
• **Platzgummer, Elmar**
**1090 Vienna (AT)**
• **Mayrhofer, Patrick**
**1060 Vienna (AT)**

(74) Representative: **Patentanwaltskanzlei**
**Matschnig & Forsthuber OG**
**Biberstraße 22**
**Postfach 36**
**1010 Wien (AT)**

(54) **CONTROLLING THE RELATIVE POSITION OF A MOVEABLE TARGET AND CHARGED-PARTICLE BEAMS IN A MULTI-COLUMN EXPOSURE APPARATUS**

(57)     For controlling relative positioning of a moveable target and a charged-particle beam array, in a charged-particle multi-beam processing apparatus for exposure of a target (107), a distance measurement system is employed which preferably includes an interferometer system employing two sets of interferometer beams ($X_1$, $X_2$; $Y_1$, $Y_2$) for measurements along different directions in a measuring plane substantially parallel to the target plane. When the target is moved through a sequence of target movement positions, at each such position the distance measurement system measures the precise current position of the target with respect to reference measuring points (55, 56) in the measuring plane. A target deviance, which describes the deviation of the calculated position and orientation of the target from the nominal target movement position and orientation, is calculated, further determining deviation amounts for the particle-optical columns, describing the deviation of the location of the base point of the columns, and respective beam displacements for the beams of the particle-optical columns which compensates the respective deviation amount, applied via deflection system of the particle-optical columns.

Fig. 6

**EP 4 654 245 A1**

**Description**

Field of the invention and description of prior art

The present invention relates to certain improvements in controlling the positioning of charged-particle beams and a moving target in a multi-column charged-particle exposure apparatus.

The applicant has realized charged-particle multi-beam apparatuses and developed the corresponding charged-particle optical components, pattern definition devices, and writing methods for multiple beams, and commercialized a 50 keV electron multi-beam writer called eMET (electron Mask Exposure Tool) or MBMW (multi-beam mask writer), used to realize arbitrary photomasks for 193nm immersion lithography, as well as masks for EUV lithography and templates for nanoimprint lithography. The applicants system has also been called PML2 (Projection Mask-Less Lithography) for electron beam direct writer (EBDW) applications on substrates. Further details can be found, for instance, in the patents US 9,053,906, US 9,520,268, US 6,768,125, US 8,222,621 and US 8,378,320 by the applicant, the disclosure of which are herewith included by reference.

Additionally, the applicant has developed multi-column-exposure apparatuses for direct-write applications on 12" wafers or 6" photomasks in US 7,214,951 and US 9,443,699 B2, the disclosure of which are herewith included by reference. A typical multi-column system includes multiple charged-particle-optical sub-columns, each of which comprises an illuminating system that delivers a broad telecentric charged-particle beam to a pattern definition system followed by a charged-particle projection optics, which includes, e.g., a number of electrostatic and/or electromagnetic lenses. Furthermore, US 2023/0015805 A1 of the applicant presented a "slim" lens optimized for multi-column applications which enables multi-column systems with increased electrical current and throughput; the disclosure of US 2023/0015805 A1 is herewith included by reference.

During the writing process in such charged-particle apparatuses, the substrate is positioned on a target stage, which continuously moves the substrate within the target plane according to a predefined path, so as to have the entire exposure area on the substrate exposed to the charged-particle beam(s). Thus, the moveable substrate is moved by the target stage through a sequence of target movement positions. However, the target stage typically has an intrinsic mechanical positioning accuracy, which is much smaller than the desired accuracy of positioning of the beam images on the substrate. In prior art, one approach to correct for this limited accuracy is by shifting the position of the beams using the charged-particle projection optics, and in particular deflection units such as electrostatic multipole lenses of the projection optics. While this approach is often effective, it is impeded, as the inventors observed, by intrinsic position deviations of the beam columns themselves, which often are well larger than the allowed accuracy of positioning of the beam images, both in absolute terms and with regard to their relative positions.

It is an aim of the present invention to provide approaches for measuring the target and beam column positioning and in particular realizing a positioning of the beam images written by the beam columns on the target at a very high accuracy.

Summary of the invention

The described problem is solved by methods as described in the attached claims. In particular, according to one aspect of the invention, a method for controlling a positioning (primarily relative positioning) of a moveable target and a charged-particle beam array, where the charged-particle beam array comprises a plurality of charged-particle beams generated by a plurality of particle-optical columns in a charged-particle multi-beam processing apparatus for exposure of a target is proposed, in which the target is moved within a target plane through a predetermined sequence of target movement positions, using a target stage of the apparatus, and where the plurality of particle-optical columns is arranged (preferably, mutually parallel) along respective longitudinal axes traversing the target plane at respective base points (which usually are mutually different), wherein each particle-optical column is configured to generate and project a respective charged-particle beam onto the target at a respective region around the respective base point for generating, in said region, a pattern portion image in accordance with a pattern to be exposed on the target, the method comprising:

    providing said charged-particle multi-beam processing apparatus including the plurality of particle-optical columns;
    providing a distance measurement system; and
    measuring the (precise) current position of the target using said distance measurement system, upon which, based on the current position of the target, a repositioning of the charged-particle beams of the particle-optical columns may be performed,
    said distance measurement system being configured for measuring the positions of at least two predefined reference measurement points of the target within the target stage within a measuring plane, which may be the same as (i.e., coinciding with) the target plane or a plane (substantially) parallel thereto, wherein the results of measuring the positions of said reference measurement points are used for calculating an actual position and orientation of the target.

Advantageously, these results are then used for deriving a target deviance describing the deviation of the actual target position and orientation from a nominal target movement position and orientation associated therewith. Advantageously, this also enables a repositioning of the charged-particle beams of the particle-optical columns based on the current position of the target, by controlling the target stage for moving to a corrected position to compensate the target deviance, and/or by calculating beam displacements for the particle-optical columns within the charged-particle beam array, each of said beam displacements describing a position correction which, with respect to the location of the respective base point of the respective particle-optical column, compensates the target deviance as applied to the respective base point.

The distance measurement system may be any suitable arrangement or device that can provide for measuring the positions of the pre-determined reference measurement points of the target with sufficient precision. In one preferable embodiment of the distance measurement system, there is provided an interferometer system employing (at least) two sets of interferometer beams propagating in an interferometer system plane parallel to the target plane, each set having at least two interferometer beams being oriented along a respective beam direction unique to the respective set (in said interferometer system plane), wherein the beam directions of the sets are mutually different, wherein the geometric extensions of interferometer beams of different sets cross (or meet) at crossing points, wherein at least two of the crossing points are within the geometric projection of a pattern portion image onto the interferometer system plane (i.e., projected along the longitudinal direction of the charged-particle beams) and are used as reference crossing points for calculating position and orientation of the target.

The method may, preferably, also comprise calculating a target deviance, with this "target deviance" describing the deviation of the calculated position and orientation of the target from a nominal target movement position and orientation associated thereto, and calculating, for at least one of the particle-optical columns, a deviation amount of the location of the base point of the respective particle-optical column which corresponds to the target deviance as applied to the location of the base point, and a beam displacement for the beam of the respective particle-optical column which compensates the respective deviation amount.

This technical solution offers a high precision of measuring the current position of the target and the relative position of the particle-optical columns with respect to the current (transient) target position. Moreover, the proposed method has the advantages that the various position measurement operations can be performed in real-time (i.e., during a writing process without interfering with the tight timing constraints of such a writing process), and that the correction of positions is achieved by the individual beam deflector systems, thus ensuring a very high accuracy of the correction, in contrast to the lower accuracy of the target stage positioning or other mechanical positioning approaches. Throughout this disclosure, wherever a rotation of the target and/or the particle-optical columns of the column array is referred to, this relates to an angle of rotation around the axis perpendicular to the target plane, also called yaw angle. Likewise, the term target orientation is to be understood as relating to the yaw angle of the target.

In another advantageous aspect of the invention, the position measurement and control is performed for each position in the sequence of target movement positions. For each such position, which is referred to as current target position, this aspect proposes the steps of

(i) positioning the target, using the mechanical target stage system, towards the current target position, thus achieving an initial target position which approximates the current target position (e.g. due to the limited positioning accuracy of the target stage system),

(ii) measuring the initial target position at positions (such as the crossing points of interferometer beams) that correspond to the reference measurement points (e.g., the reference crossing points in the case of an interferometer system), to obtain initial target position coordinates,

(iii) calculating, using the initial target position coordinates and coordinates of the reference measurement points (or reference crossing points, as the case may be), a lateral displacement and stage yaw angle of the target in the initial target position with respect to the current target position,

(iv) calculating, for each particle-optical column and the respective beam thereof, a beam displacement and a yaw correction which compensates for the difference between the initial target position with respect to the current target position and calculated stage yaw angle for the location of the base point of the respective particle-optical column, and

(v) applying to each beam a correction of the position and orientation of the respective beam image on the target in accordance with the respective beam displacement and yaw correction; this may, suitably, be achieved by means of a deflection system provided in the particle-optical column of the respective beam.

It is often advantageous to have the reference crossing points at locations such that they respectively coincide with positions of base points of corresponding particle-optical columns, or at least fall within the geometric projection of a particle-optical column onto the measuring plane (using, e.g., a projection of a representative cross-section of the particle-optical column, or a "shadow" projection). Generally the number of particle-optical columns, and thus the number of base points, is larger that than the number of reference crossing points. Thus, it is often suitable to choose base points that are mutually arranged at large distances to each other, as reference crossing points.

Furthermore, in many embodiments it is suitable for reducing the amount of calculations to provide that measuring the current position of the target is performed with respect to only the at least two predefined reference measurement points (which typically correspond to respective base points of particle-optical columns). Preferably, these two (or more) predefined reference measurement points may be crossing points which have extremal values of coordinates used in the distance measurement system. Such measuring procedure may preferably include the steps of

determining the actual positions of the reference columns (i.e., the particle-optical columns corresponding to the predefined reference measurement points),

calculating, using actual positions of said reference columns, a position deviance of the entire charged-particle beam array, said position deviance including a yaw angle and positional offset, and

correcting the effect of the position deviance on the charged-particle beam array by repositioning the beam of each of the plurality of particle-optical columns (109) by a position correction suitable to compensate the position deviance as applied to the respective base point of the respective particle-optical column.

Another aspect of the invention addresses the facts that the actual positions of the particle-optical columns may slightly but significantly deviate from their nominal positions in the respective array, and that the positioning movements of the target stage system often incur small variations of the target position which may cause imprecise measurement results of the interferometer system. Thus, in many embodiments it is of advantage to calculate beam displacements by taking into account actual positions of the base points of the particle-optical columns within the charged-particle beam array, and for each particle-optical column the respective beam displacement is calculated from the lateral displacements that have been determined at the reference measurement points (or reference crossing points, as the case may be). This calculation can, for instance, be done by interpolating the lateral displacements or the respective deviation amounts for the actual position of the particle-optical column base points within the charged-particle beam array. The positions of the base points of the particle-optical columns may determined (e.g. with regard to the above-described process of steps i-v, preferably prior to step iv) for instance by way of an initial calibration process in which:

a test substrate is exposed using a write process where the particle-optical columns write each a test pattern on said test substrate; the test patterns may e.g. be copies of a (predefined) template pattern, which comprising a pattern figure, such as a cross or star shape, having multiple components radially arranged around a central location; and thus in the resulting test pattern the copies of the template patterns will be arranged in an array corresponding to the array of the particle-optical columns,

the positions of the test patterns are measured (for which any suitable placement measurement tool of prior-art may by used), and

the positions thus measured are compared to nominal positions of the respective particle-optical columns and recorded with respect to the differences from said nominal positions. The positions determined by this approach can then be used for correcting individual position deviations of the columns by using, e.g., the respective deflection system mentioned. In contrast, the yaw correction is usually assumed to be uniform for all beams.

In a further suitable aspect of determining the actual positions of the particle-optical columns (i.e., their base points), it is proposed that, for each particle-optical column, a deviation of the actual position of the respective base point from a respective nominal position of the respective base point (within the charged-particle beam array) is determined by measuring a difference between nominal and measured positions for the respective particle-optical column for a plurality of test positions, where this plurality of test positions extends over a position range sampling the desired range of motion of the target stage, and from this a deviation of the actual position of the respective base point from a respective nominal position of the respective base point may be determined. It is then possible that, based on the deviations thus determined, a position error map is generated using a predetermined interpolating approach for the deviation between the location of the test positions; this position error map indicates the deviation of position (in particular of the particle-optical columns) as a function of the position of the nominal base points. Applying this correction may, in many embodiments, particularly advantageous be done in "real time", i.e., during a writing process involving exposure of the target in the multi-beam processing apparatus. More specifically, the results of measuring the positions of reference measurement points may be applied (in "real time") to the positions of the particle-optical columns as used for correcting the position of beam images generated on the target by said columns, where the positions of the columns (or the locations of the base points corresponding thereto) are adjusted in "real time" using the position error map. In the special case of using an interferometer system, which involves measuring the positions at (reference) crossing points, the positions of the columns (or base points) are adjusted in "real time" using the position error map with respect to the nominal position of the columns (or base points thereof) derived from the results of the positions at respective crossing points and pertinent position corrections. In particular, where the location of a (reference) crossing point is within the geometric projection of a particle-optical column onto the measuring plane, it will be suitable to use, for the position correction of that column (or its base point), the data of this crossing point (in particular the correction derived from the position error map for this crossing point).

In many embodiments the particle-optical columns are, within the charged-particle beam array and as regards their respective base points, arranged according to a pre-defined array, which often is a regular array, within which the particle-optical columns form at least two rows extending parallel to a main direction of movement of the target along the mentioned sequence of target movement positions, with these rows being spaced apart by a row offset as measured perpendicular to this main direction.

In accordance with one particular aspect of the invention, the operations for measuring the (highly precise) current position of the target and, if applicable, calculating beam displacement for beams to compensate for deviations of the target current position from a nominal position may be performed in "real time", i.e., during a writing process performed on a substrate positioned at the location of the target. The operations for measuring the current position of the target and, if applicable, calculating beam displacements may advantageously be carried out within a total time not exceeding a predetermined delay time, said delay time being preferably 10 μs.

In many embodiments of the invention, a processing circuit may be used that includes one or more field-programmable gate arrays (FPGA) for performing or controlling the steps measuring the current position of the target and optional further calculations based thereon.

Many embodiments of the invention further include a position fine-adjustment procedure which serves to correct or compensate systematic errors of the distance measurement system. This procedure advantageously comprises

> obtaining a position error map, said position error map indicating the position error in the distance measurement system as a function of the respective position,
> obtaining, from the distance measurement system, distance-measurement values along a number of coordinate values,
> correcting the distance measurement values using the position error map, to obtain adjusted distance-measurement values, and
> using the adjusted distance-measurement values to determine center data, including a center position and yaw angle of the target stage or target,

and optionally also transmitting the center data to a stage control unit for correction of the position of the target stage or target.

The position fine-adjustment procedure may also provide that the step of obtaining distance-measurement values along a number of coordinate values is carried out only for a number of pre-determined crossing points, said crossing points having extremal values of the coordinates in the distance measurement system.

For determining the position error map used in the position fine-adjustment procedure the following steps may be suitable:

> performing an exposure on a test substrate provided with a calibration pattern comprising an array of registration markers and processing said test substrate,
> determining the positions of the registration markers,
> obtaining positional displacements of the markers by comparison with respective nominal positions of the markers, and
> generating the position error map from said positional displacements;

wherein a suitable embodiment of the step of performing an exposure on a test substrate (where an array particle-optical columns is used as mentioned, which each have a pattern definition device for defining a pattern portion image that is written to the target) provides that the exposure of the registration markers is carried out such that for the exposure of said registration markers only a center portion of the pattern definition devices is used. This has the advantage that the center region of the pattern definition device is typically associated with minimal imaging errors.

Brief description of the drawings

In the following, in order to further demonstrate the present invention, illustrative and non-restrictive embodiments are discussed, as shown in the drawings, which show schematically:

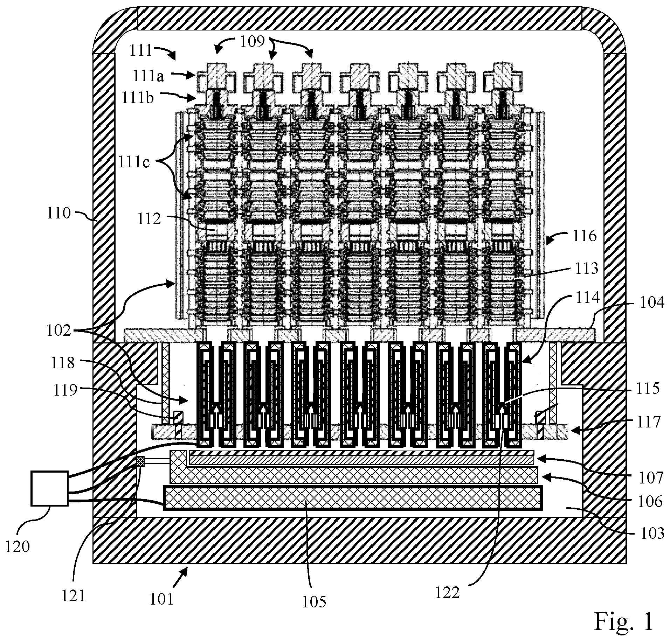

Fig. 1               a multi-column writer tool suitable in a longitudinal section, which includes a distance measurement system and pertinent control unit;

| Fig. 2 | depicts an example of a sub-column array according to a regular rectangular array; |
| Fig. 3 | depicts another example of a sub-column array according to a regular staggered array; |
| Fig. 4 | is a flow-chart of the operations performed with the control unit of the distance measurement system; |
| Fig. 5 | depicts one layout of the interferometer system reference crossing points of the distance measurement system with the sub-column array of Fig. 2; |
| Fig. 6 | depicts another layout of the interferometer system reference crossing points, relating to the sub-column array of Fig. 3; |
| Fig. 7 | illustrates a target in an exemplary general location, and relating various quantities of the distance measurement system; |
| Fig. 8 | shows a test substrate used for a calibration procedure to determine the precise position of the base points of the sub-column relative to the measurements of the interferometer system; |
| Fig. 9 | is flow-chart illustrating the processing of various types of position-related data; |
| Fig. 10 | shows a multipole electrode having eight sectorial electrodes in a cross-sectional view; |
| Fig. 11 | is a detail of the gap between two of the sectorial electrodes of the multipole electrode of Fig. 10; |
| Fig. 12 | shows a variant of a multipole electrode having four sectorial electrodes in a perspective view; |
| Figs. 13 and 14a-c | illustrate an exemplary interferometer system relating to the layout of Fig.6, where Fig. 13 is an overall plan view, and Fig. 14a, 14b, and 14c are views of one interferometer head along the Z axis, X axis, and Y axis, respectively. |

Detailed description of embodiments of the invention

The detailed discussion of exemplary embodiments of the invention given below discloses the basic ideas, implementation, and further advantageous developments of the invention. It will be evident to the person skilled in the art to freely combine several or all of the embodiments discussed here as deemed suitable for a specific application of the invention. Throughout this disclosure, terms like "advantageous", "exemplary", "typical", or "preferred" indicate elements or dimensions which are particularly suitable (but not essential) to the invention or an embodiment thereof, and may be modified wherever deemed suitable by the skilled person, except where expressly required. It will be appreciated that the invention is not restricted to the exemplary embodiments discussed in the following, which are given for illustrative purpose and merely present suitable implementations of the invention. Within this disclosure, terms relating to a vertical direction, such as "upper" or "down", are to be understood with regard to the direction of the particle-beam propagating within a respective particle-optical column, running downwards ("vertically") along a longitudinal axis. This longitudinal axis is generally identified with the Z direction, to which the X and Y directions are transversal.

**Lithographic Apparatus**

Generally, the invention is suitable for generic multi-column charged-particle exposure apparatuses such as arrays of Variable Shaped Beam or Gaussian Beam systems. Many favorable embodiments of the invention are realized in a multi-column multi-beam charge particle apparatus such as the multi-column writer tool shown in a schematic sectional view in Fig. 1. The writer tool employs a charged-particle beam formed from charged particles which may be electrons or ions (for instance ions of positive electric charge).

The writer tool 101 comprises a vacuum housing 110 for the multi-column charged-particle optics 102, a target chamber 103 onto which the multi-column charged-particle optics is mounted by means of a column base plate 104. Within the target chamber 103 is an X-Y stage 105, e.g. an air-bearing vacuum stage, which is controlled by a distance-measurement system 121, and corresponding control unit 120, onto which a substrate chuck 106, preferably an electrostatic chuck, is mounted using a suitable handling system. The chuck 106 holds the substrate 107 serving as target, such as a silicon wafer or a photomask with an electron or ion beam sensitive resist layer.

The multi-column optics 102 comprises a plurality of sub-columns 109 (the number of columns shown is small in the depiction for better clarity, and may represent a much larger number of columns that are present in the multi-column apparatus in some implementations). Preferably, the sub-columns 109 have identical setup and are installed side-by-side with mutually parallel axes. Each sub-column has an illuminating system 111 including an electron or ion source 111a, an extraction system 111b, and an electrostatic multi-electrode condenser optics 111c, delivering a broad telecentric charged-particle beam to a pattern definition (PD) system 112 being adapted to let pass the beam only through a plurality of apertures defining the shape of sub-beams ("beamlets") permeating said apertures (beam shaping device), and a demagnifying charged-particle projection optics 116, composed of a number of consecutive electro-magneto-optical projector stages, which preferably include electrostatic and/or magnetic lenses, and possibly other particle-optical devices. In the embodiment shown in Fig. 1, the projection optics 116 comprises e.g. a first lens 113 which is an accelerating electrostatic multi-electrode lens, whereas a second lens 114, located downstream of the first lens, is realized using an electromagnetic lens.

In each sub-column 109, the first lens 113 of the projection optics forms a first cross-over of the particle beam, whereas the second lens 114 forms a second cross-over. In the second lens a beam aperture 115 is configured to filter out beam parts which deviate from the respective optical axis since they have been deflected in the PD system. Each second lens 114 of the sub-columns may be preferably mounted on a reference plate 117 which is mounted by suitable fastening means 118 onto the column base plate 104. Mounted onto the reference plate 117 are parts 119 of an off-axis optical alignment system. For positioning and shaping the beams as it traverses the columns, each sub-column comprises a deflection system including a multipole electrode system to be used in conjunction with the projection optics. The write multipoles 122, in particular, serve to position the patterned beams of each sub-column in relation to each other and to the stage 105.

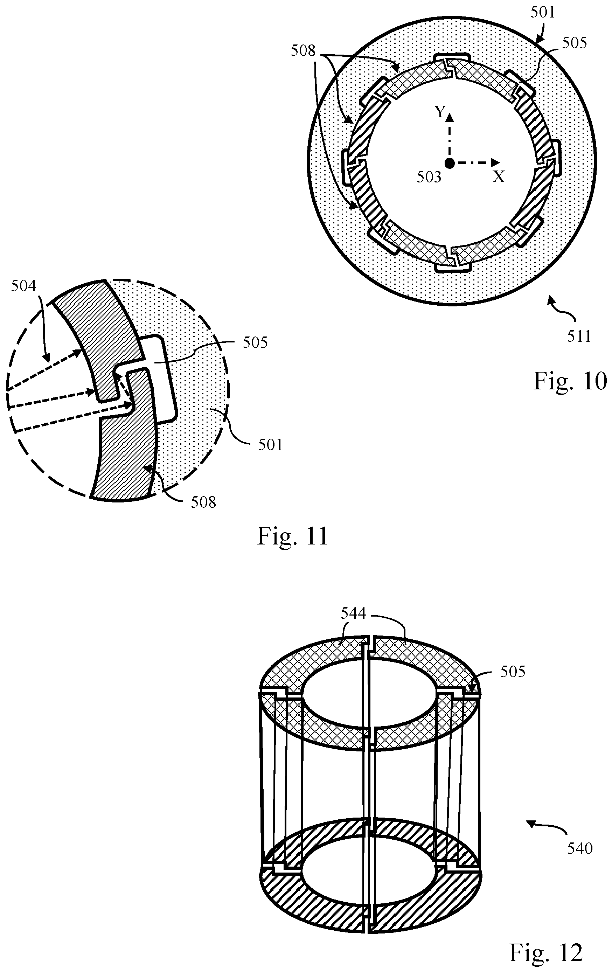

Figs. 10, 11, and 12 show suitable exemplary embodiments of the multiple electrodes in the multipole electrode system, in particular the write multipoles 122. Each of the multipole electrodes is composed of three or more metallic ring sectorial components serving as electrodes of the multipole electrode (sub-electrodes), which hereinafter are also called rods. Preferably, the rods are of identical geometry. A depiction of a multipole electrode 511 with eight rods 508 (sectorial electrodes) in a cross-sectional view is shown in Fig. 10; Fig. 11 shows an enlarged detail of a gap range between two of the rods. Fig. 12 shows a variant of a multipole electrode 540 with four sectorial electrodes 544. Preferred numbers of rods within a multipole electrode are four, six, eight, twelve or sixteen, depending on the desired effects to be achieved.

Referring to Fig. 10, the rods 508 are located within a surrounding sleeve serving as support 501. The rods 508 can be individually applied electric potentials by means of their respective external power supply units. Additionally, a global offset voltage may be applied to have them behave as additional electrostatic lenses. By virtue of the different voltages applied to the individual rods 508 various field configurations of dipole, quadrupole or higher order electrostatic fields can be realized, with the purpose of shaping the particle beam crossing their corresponding transversal section of the optical axis 503. With respect to a typical application, the voltages applied to the rods 508 are typically in the order of up to a few tens of volts. Such beam shaping can be used to compensate for errors due to imperfections of the optical system, such as magnetic inhomogeneities, mechanical manufacturing and/or assembly accuracies. In this respect, the multipoles can correct the beam position with respect to the optical axis 503 when used as dipoles, whose directions in the plane defined by the X and Y axes can be arbitrary if at least four different voltages +V1 (hatched rods to the right hand side), -V1 (hatched rods to the left hand side), +V2 (cross-hatched rods to the top), -V2 (cross-hatched rods to the bottom) are applied to the rods. Additionally, it is possible to compensate for astigmatism or other higher-order distortions by the multipoles when the latter are used as quadrupole or higher-order multipoles, by applying suitable voltages at the individual rods, in a manner similar to the dipole case. The gaps 505 between the sectorial electrodes forming the rods 508 are advantageously angled (or zig-zag shaped, "labyrinth"), so as to avoid that particles 504 diverting from the beam which propagates within the central space of the multiple electrode can travel to the outside of the multiple electrode, possibly affecting the support 501 or other outer components, but will impinge on a surface of a rod. At the outer sides of the rods 508 the gaps 505 end in pouches which serve to collect the particles and drain their electric charge to a drain electrode (not shown). This serves to avoid the build-up of electric charges and associated stray electric fields which otherwise might affect the charged-particle beam propagating through the multipole electrode 511.

The reference plate is fabricated from a suitable base material having low thermal expansion, such as a ceramic material based on silicon oxide or aluminum oxide, which has the advantage of little weight, high elasticity module and high thermal conductivity, and may suitably be covered with an electrically conductive coating, at least at its relevant parts, in order to avoid charging (by allowing electrostatic charges to be drained off).

The PD system 112 of each sub-column serves to form the particle beam into a plurality of so-called beamlets which contain the information of the pattern to be transferred to the target. The structure, operation and data-handling of the PD system are disclosed in US 9,443,699 and US 9,495,499 of the applicant.

**Multi-Column architecture**

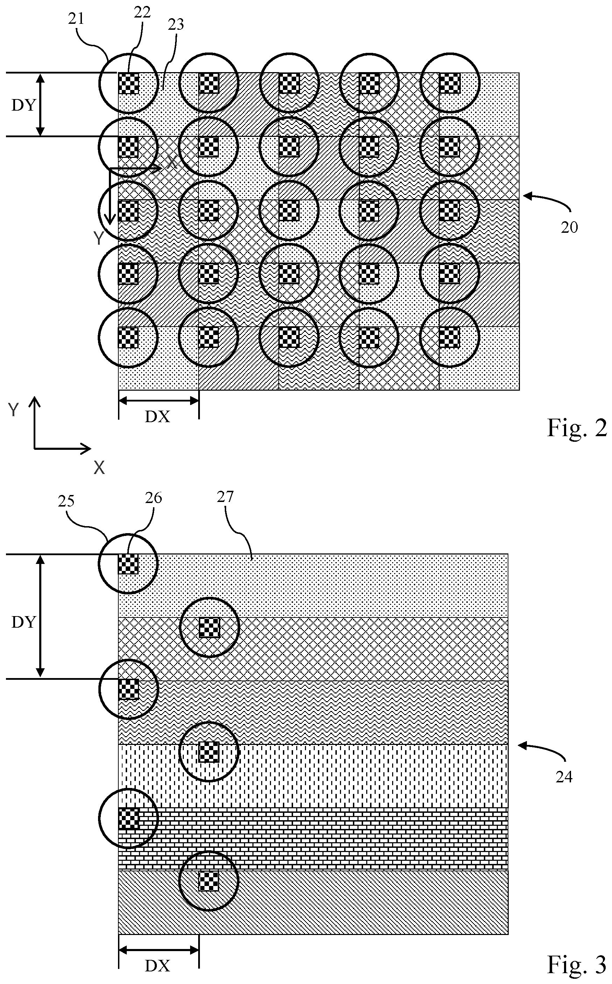

Exemplary sub-column arrays with corresponding column exposure fields suitable for the invention are illustrated in Fig. 2 and Fig. 3.

In Fig. 2, a rectangular layout with column exposure fields restricted in the X and Y directions is illustrated. The sub-columns 21 with corresponding patterned beams 22 (the size is exaggerated for clarity and typically smaller then depicted) are arranged in a regular grid with respective pitches DX and DY, spanning the whole exposure area 20 (part of a substrate to be exposed). The exposure area is partitioned into column exposure fields 23 (illustrated by different ways of hatching). In this embodiment of the invention, the column exposure field size matches the sub-column pitch, that is, the beam 22 of each sub-column 21 exposes a single column exposure field 23.

Fig. 3 shows another layout of a column array. Here, the sub-columns 25 with corresponding patterned beams 25 are arranged in a staggered grid with pitches DX and DY and offset DY/2 between the first and second column. The column exposure fields are restricted in the Y direction only and form stripes 27 spanning the exposure area 24; these stripes 27 correspond to the column exposure fields 23 of Fig. 2.

In variants of the arrays, the column exposure fields may overlap in a regular or irregular manner to allow for smooth transitions between sub-columns, compensation of misplaced sub-columns or mixing of sub-column aberrations.

Other array layouts may provide variants of and/or combine the two exemplary embodiments described above, e.g. by combining the column layout of Fig. 2 with the column exposure fields of Fig. 3.

**Measuring and controlling stage and beam position**

The X-Y stage 105 serves to ensure appropriate continuous positioning of the target, which usually involves constant motion of the substrate relative to the sub-column beams. Moreover, the stage 105 is advantageously configured to compensate unwanted vibrations, forces or torques, for instance introduced by manufacturing imperfections of the stage or external perturbations. It should be noted that not only the position, but also the orientation of the substrate, in particular its yaw, which may change as the stage traverses its range of motion, is relevant for sufficiently accurate exposure results. Herein, the term "yaw" denotes the rotation around the axis orthogonal to the target plane. For monitoring the position and orientation of the stage, and hence the relative position of the sub-column array 109 and the substrate 107, a distance-measurement system 121 is utilized, which may be, for instance, based on multiple laser interferometers as shown in the present embodiment. To ensure minimal deviation from the desired position, a control unit 120 employing one or multiple controllers forming a control loop for the distance measurements and the stage control system is provided.

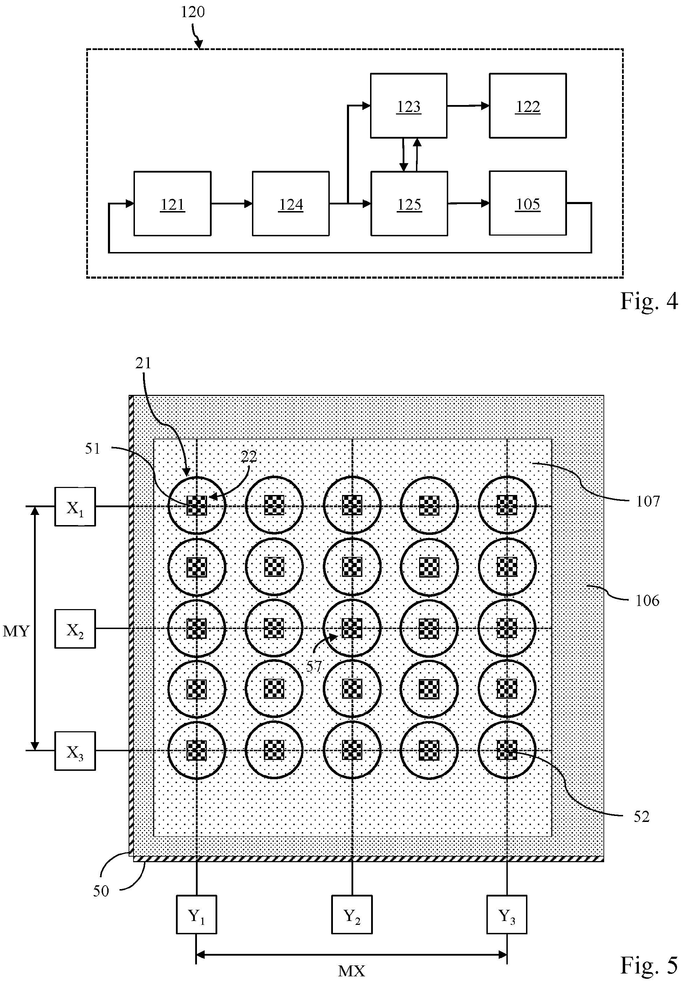

Fig. 4 shows an exemplary flow-chart illustrating the data processing carried out at the control unit 120 and its control loop. The distance-measurement system 121 registers X and/or Y stage positions for multiple positions and directions. The measured positions are fed into a suitable processing unit 124, for instance a microcontroller and/or a processing circuit including one or more field-programmable gate arrays (FPGA), which processes the position data with a suitable low-pass filter, applies stage-position dependent position fine-adjustments and calculates stage position and rotation states. The processed data is passed on to the beam control unit 123 (also referred to as writing control unit, WCU), which coordinates the placement of the column beams (controlled by the write multipoles 122) and the stage 105 and can effect appropriate repositioning of the beamlets so as to compensate differences between measured and desired positions. Additionally, the position data is provided to the stage control unit 125, which ensures that the stage travels to the desired position with minimal stage yaw. The changed position is then registered by the distance-measurement system 121, closing the control loop.

The distance-measurement system 121, which according to the invention comprises multiple distance-measurement devices, is implemented using commercially available laser interferometer systems with a measurement accuracy of around 0.2 nm. The interferometers are positioned on predetermined fixed reference points, for instance inside the vacuum chamber 103, and measure the distance in X or Y direction to a plane mirror mounted or coated onto the stage 105 or chuck 160.

**Distance-measurement system architecture**

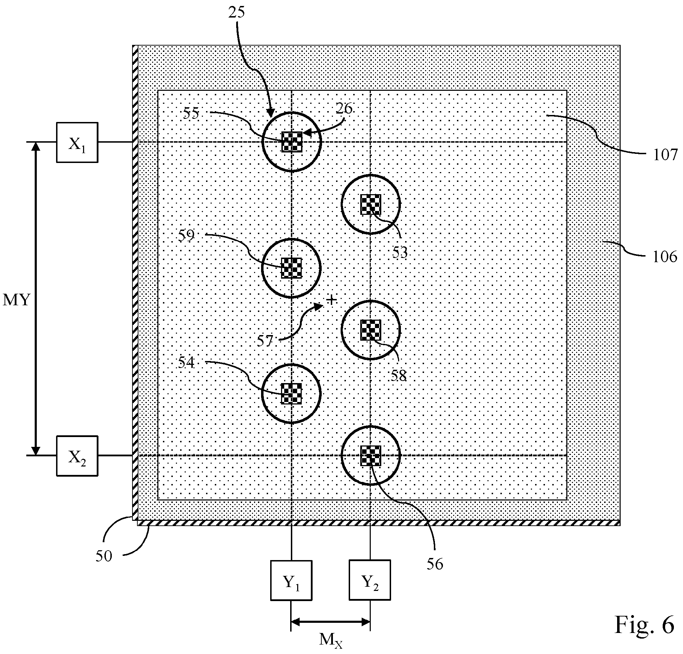

According to the invention, the distance-measurement devices (e.g. interferometer beams) of the distance-measurement system 121 are arranged such that the lines (i.e., the geometric extensions) of the beams in X- and Y-directions (or generally, along two of the different directions) form at least two crossing points (also referred to as "interferometer crossings" or simply "crossings", corresponding to reference measurement points of the invention). Favorably, at least two interferometer crossings are positioned in or close to the center of the charged-particle beams generated by respective sub-columns, preferably of those sub-columns that are located towards or at opposing corners of the sub-column array. The alignment of an interferometer crossing with a beam center allows the tracking of the position of the respective beam center, independent of the stage yaw, which in turn enables the generation of a fine-adjustment map for the respective beams in a straightforward manner (see below for further details). Furthermore, it is advantageous to choose the crossings such that they have a large distance in both axial directions, since this allows for yaw angle measurements with a large lever. Thus, by choosing crossings at a maximal distance to each other it is possible to achieve an optimal accuracy of the position measurement and in particular yaw measurement. Figs. 5 and 6 show examples of suitable interferometer arrangements for the embodiments of Figs. 2 and 3.

Fig. 5 illustrates one example of an arrangement with distance measurements employing three interferometer beams per direction, namely $N$=3 beams at coordinates $X_1$, $X_2$, $X_3$ and $M$=3 beams at coordinates $Y_1$, $Y_2$, $Y_3$, as one example among many conceivable implementations, realizing an overdetermined arrangement. The interferometer beams impinge on the chuck 106 at attached or coated mirror surfaces 50. The (imaginary) extended beam trajectories form 3x3 = 9 intersections, corresponding to crossing points (reference measurement points), which respectively are located in the center of corresponding sub-columns beams 22. According to favorable embodiments of the inventions, the crossing points 51, 52 are positioned such that they include positions of the sub-columns in the corners of the array, and further having large, preferably maximal, axial offset $MX$, $MY$, which allows for determination of the stage yaw with very high accuracy. Another exemplary arrangement with four interferometer beams ($N$=$M$=2) at $X_1$, $X_2$ and $Y_1$, $Y_2$ is depicted in Fig. 6.

According to the invention, the geometric extensions of the interferometer beams form at least two crossing points, and these crossing points are located in or near the center of sub-column beams 26. Preferably, the crossing points are located with respect to sub-column positions such that they include opposing corners of the sub-column array, as illustrated by crossings 53 and 54 or crossings 55 and 56 of Fig. 6. Advantageously, the crossings are chosen such that they have large or even maximal distances $MX$, $MY$ in both axial directions, which, in the embodiment shown in Fig. 6 is the case for the pair of crossings 55 and 56.

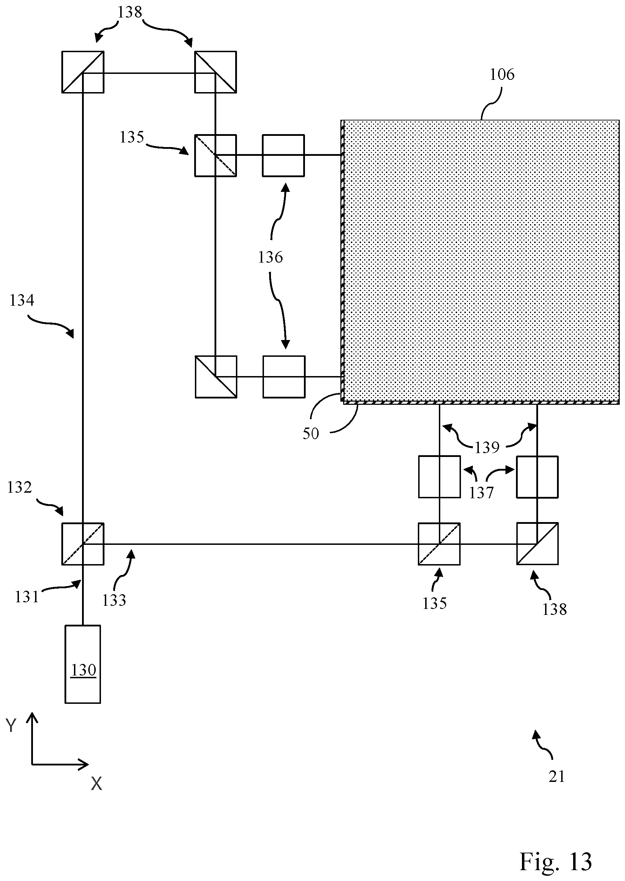

Fig. 13 illustrates one typical, albeit exemplary, implementation of a distance-measurement system 21 with interferometry. A laser head 130 generates a beam 131, which is split by a primary beam splitter 132 into sub-beams 133, 134. Secondary beam splitters 135 further subdivide the sub-beams to feed a set of interferometer heads 136 performing horizontal and a set of interferometer heads 137 performing vertical measurements (using measurement beams 139) of the distance to mirrors 50 fixed on the chuck 106. The interferometry system typically further comprises additional elements such as so-called beam benders 138 and/or beam manipulators (not shown).

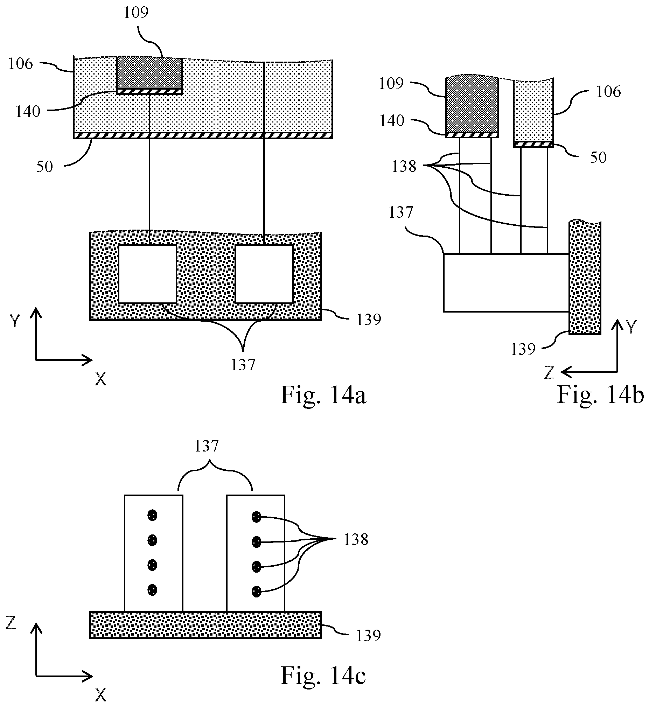

Referring to Figs. 14a-c, in a favorable embodiment of the invention, at least one interferometer head 137 of the sets of interferometers performing horizontal and vertical measurements is a multi-axis interferometer head, which serves to measure multiple vertical offsets 138 to determine the stage pitch. Figs. 14a-c represent views at the interferometer head 137 along the Z, X, and Y axes, respectively, of the system. The interferometer heads 137 measuring vertical distance are fixed to a mount 139, e.g., the same mount that the stage is fixed to. In a further favorable development of the invention, the multi-axis interferometer may suitably also comprise at least four beams configured for additionally measuring the distance and pitch of the column 109 with column mirror 140 associated with the interferometer head, and further serving as an interferometric reference beam for the set of interferometer heads. This configuration has the advantage that only relative movement between column 109 and chuck 106 is tracked. In a further embodiment, the interferometer system tracks (i.e., measures) the absolute positions of (at least) two columns, and this can be used to determine a deviation of the position from nominal positions: Such deviation may be caused e.g. by thermal deformation of the support arrangement of the array of columns. The deviation of position may, typically, comprise an offset deviation plus a rotational deviation of the entire array of columns. In this embodiment, the deviation of position is corrected in a similar manner as with the determination of the stage positional and rotational error, without measuring the position of each column in the array individually; rather, the determination is based only on the measurement of the selected (at least) two columns, whose positions serve as reference measurement points. The position deviation thus determined can, for instance, be corrected via repositioning of the beams of the respective columns.

## Distance-measurement system and chuck coordinates

In the following, exemplary procedures are described to illustrate how measurements of a distance-measurement system 121 can be utilized to track positions on the chuck and/or mask.

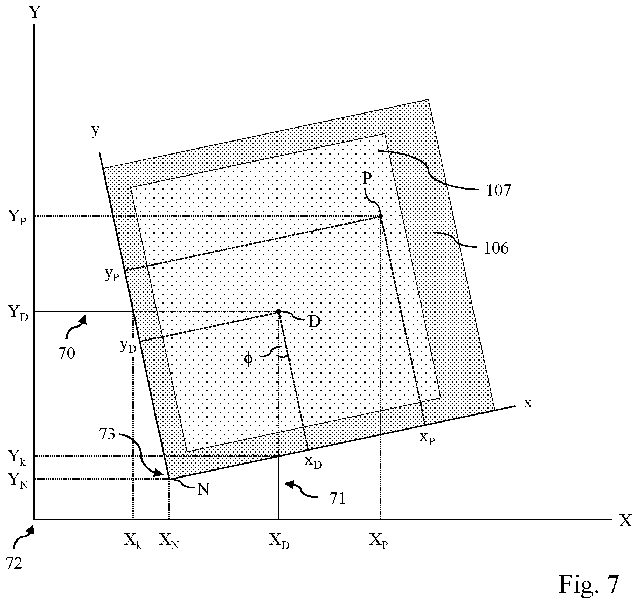

Fig. 7 depicts a distance-measurement system having a distance-measurement coordinate system 72, denoted with capital letters X, Y, and two beams 70, 71 are arranged parallel to the X, Y axes respectively with their respective interferometer heads positioned at $(0, Y_D)$ and $(X_D, 0)$ (the coordinates X, Y are defined suitably so as to conform to this specific definition of head positions). Thus, the beams form a crossing $(X_D, Y_D)$. The chuck 106, which holds a mask substrate 107, is offset by $(X_N, Y_N)$ and rotated by an angle $\phi$ (which is typically in the order of a $\mu$rad and exaggerated in Fig. 7 for illustration purposes), giving rise to a chuck coordinate system 73 (denoted with lower-case letters x,y) with origin $N$. The mask substrate 107 (in the following simply referred to as "substrate") has a further offset and rotation against the chuck 106, which can be corrected or compensated by methods that are not part of the invention and are not considered here.

For an arbitrary point $P$ with coordinates $X_P$, $Y_P$ in the distance-measurement coordinate system, the chuck coordinates $x_P$, $y_P$ are determined for given distance measurements $X_k$, $Y_k$ and yaw angle $\phi$ with

$$\begin{pmatrix} x_P \\ y_P \end{pmatrix} = R^T \begin{pmatrix} X_P - X_N \\ Y_P - Y_N \end{pmatrix} \qquad (1)$$

where

$$R = \begin{pmatrix} \cos\phi & -\sin\phi \\ \sin\phi & \cos\phi \end{pmatrix} \text{ and } \begin{pmatrix} X_N \\ Y_N \end{pmatrix} = \begin{pmatrix} X_k\cos^2\phi + (Y_D - Y_k)\cos\phi\sin\phi + X_D\sin^2\phi \\ Y_k\cos^2\phi - (X_D - X_k)\cos\phi\sin\phi + Y_D\sin^2\phi \end{pmatrix}.$$

Using the small-angle approximation $\sin\phi \approx \phi$, $\cos\phi \approx 1$, the above simplifies to

$$\begin{pmatrix} x_P \\ y_P \end{pmatrix} \approx \tilde{R}^T \begin{pmatrix} X_P - X_D \\ Y_P - Y_D \end{pmatrix} + \begin{pmatrix} X_D - X_k \\ Y_D - Y_k \end{pmatrix} \qquad (2)$$

with $\tilde{R} = \begin{pmatrix} 1 & -\phi \\ \phi & 1 \end{pmatrix}$. In particular, the beam crossing D in chuck coordinates is given by

$$\begin{pmatrix} x_D \\ y_D \end{pmatrix} \approx \begin{pmatrix} X_D - X_k \\ Y_D - Y_k \end{pmatrix}, \qquad (3)$$

so, disregarding the constant offset $X_D$, $Y_D$, the position of the distance measurement beam crossing (and aligned sub-column) on the substrate is directly tracked by the distance measurement devices, independent of the substrate rotation. The offset can be determined, e.g., by calibrating on a beam control target with known chuck coordinates.

**Calculation of substrate orientation and sub-column positions**

For a distance-measurement system with at least two interferometer crossings such as the embodiments shown in Fig. 5 and Fig. 6, by averaging (2) over multiple beams, we get

$$\begin{pmatrix} x_P \\ y_P \end{pmatrix} \approx \tilde{R}^T \begin{pmatrix} X_P - X_C \\ Y_P - Y_C \end{pmatrix} + \begin{pmatrix} X_C - \bar{X} \\ Y_C - \bar{Y} \end{pmatrix} \qquad (4)$$

where $X_C = \frac{1}{M}\sum_{m=1}^{M} X_{D_m}$, $Y_C = \frac{1}{N}\sum_{n=1}^{N} Y_{D_n}$ are the coordinates (in the distance-measurement coordinate system) of the center C (or 57) of a distance-measurement system with $M + N$ beams at $X_{D_1}, \dots, X_{D_M}$ and $Y_1, \dots, Y_{D_N}$ and $\bar{X} = \frac{1}{N}\sum_{n=1}^{N} X_N$, $\bar{Y} = \frac{1}{M}\sum_{m=1}^{M} Y_m$ the corresponding average distance measurements. In particular, the chuck coordinates $x_C$, $y_C$ of the center C (denoted by 57 in Figs. 5 and 6)

$$\begin{pmatrix} x_C \\ y_C \end{pmatrix} \approx \begin{pmatrix} X_C - \bar{X} \\ Y_C - \bar{Y} \end{pmatrix} \qquad (5)$$

are determined by $\bar{X}$, $\bar{Y}$ with a constant offset and also independent of yaw angle $\phi$. Since it averages the error contributions of the individual distance-measurement device, equation (4) can advantageously be applied to track the chuck positions (or substrate positions) $x_{S_1}, \dots, x_{S_K}$ and $y_{S_1}, \dots, y_{S_K}$ of the sub-column array (including those that are not tracked by a distance-measurement beam crossing) by plugging the fixed sub-column stage-coordinate offsets to the distance-measurement system center into equation (4). For this purpose, the sub-column stage-coordinate offsets can be determined with sufficiently high accuracy, for instance, by using a beam calibration target or by exposing a calibration pattern with each sub-column on a calibration substrate and measuring the offset to the center with an offline metrology tool. The stage yaw angle $\phi$, which is needed in equation (4), can be suitably determined by solving

$$\phi = \arctan \frac{X_2 - X_1}{Y_{D_1} - Y_{D_2}} \approx \frac{X_2 - X_1}{Y_{D_1} - Y_{D_2}}, \qquad (6)$$

favorably utilizing the largest realized distance between distance measurement beams, e.g. $Y_{D_1}$ - $Y_{D_2}$ = $MY$ in the embodiment of Fig. 5 or Fig. 6. In an overdetermined distance-measurement arrangement such as the one of Fig. 5, the yaw angle may alternatively be determined using all measurements in a linear least-squares fit of the slope $a$ in the measurements

$$\phi \approx \sin\phi = \arg\min_a \sum_{m=1}^{M} \left(a\left(Y_{D_m} - Y_C\right) - X_m\right)^2 + \sum_{n=1}^{N} \left(a\left(X_{D_n} - X_C\right) - Y_n\right)^2.$$

**Fine-adjustment of distance measurements and column position**

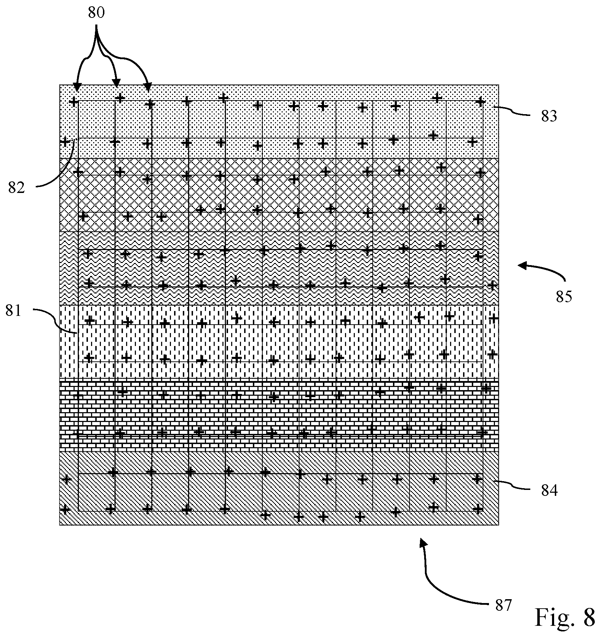

Due to imperfections in the mirror surface 50, the (e.g. interferometric) measurements of the distance measurement system may exhibit systematic errors in the order of 100nm, which may be problematic in terms of desired accuracy as needed in high-precision lithography. To deal with this possible problem, a further aspect of the invention is proposed, which advantageously utilizes an additional fine-adjustment of the distance measurements, which may be based on position-error maps which are generated with calibration exposures. The implementation of a position fine-adjustment is discussed below referring to Fig. 8 and primarily in the context of the embodiments of Fig. 6, where precisely two distance-measurement beam crossings 51 are aligned with corresponding sub-column centers 22.

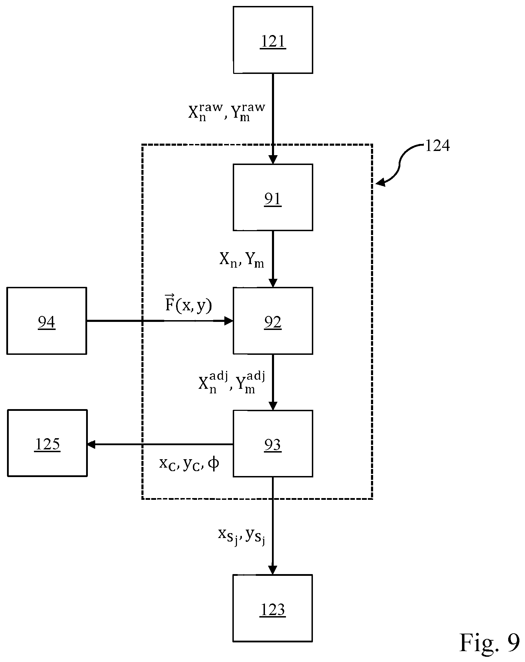

Referring to Fig. 8, a calibration procedure may be based on a test exposure on a substrate 87 which is provided with a calibration pattern comprising an array of registration markers 80 (shaped as e.g. crosses in the example shown, although other shapes of markers may be used as well) is exposed in a regular grid across an exposure area 85 on a substrate. In the case of a multi-column multi-beam charged particle exposure apparatus, it may be suitable to write the calibration pattern using a center portion of the pattern definition device of each column, for instance employing a comparatively small number of beamlets of the respective pattern definition device. This is preferable because the center of the pattern definition device typically exhibits the least amount of charged-particle optical aberrations, which may be complicating for the calibration measurement. As explained above in relation to Figs. 2 and 3, the exposure area is further partitioned into multiple column exposure fields 23, 27, which in Fig. 8 are indicated by different types of hatching (corresponding to the layout of Fig. 3), and each of which is exposed by a single sub-column respectively. Once the calibration pattern is exposed to the substrate and the substrate is processed (e.g. developed), the marker positions on the thus processed substrate are determined and then compared to nominal positions 81 on the regular grid, using a state-of-the-art registration metrology tool (e.g. ZEISS PROVE® 20ext). Hence, a positional displacement 82 (which is shown exaggerated for better clarity in Fig. 8) for each marker position is obtained, containing displacement vectors (from nominal to effective) for each position on the exposure area. The set of displacements 82 may be modelled or interpolated using a suitable interpolation approach such as bilinear, biquadratic or spline interpolation, so as to obtain a position correction map $\vec{F}(x, y)$ (at step 94 in Fig. 9, see below). It is to be noted that, in a further extension, the position correction map may also comprise error components for a potential misalignment of the sub-column position 22 (with respect to a nominal position of an interferometer crossing 51 of the distance-measurement system), which is typically constant over each sub-column exposure field, but may vary from one sub-column to the next. Often the position correction map in the column exposure fields 83 and 84 which are associated with sub-columns at crossing points used in the interferometer beam system (such as crossings 55, 56 of Fig. 6) is of particular importance since these exposure fields 83, 84 are exposed by sub-columns which are positionally controlled by a crossing of distance-measurement beams. Here, the position correction map represents errors in the interferometer system (e.g. due to insufficient mirror flatness), since the respective beam positions are tracked directly, independent of stage yaw. For the very first exposure of the calibration pattern, the position correction map may be initialized to a zero map, or an initial best guess is utilized (which may be obtained from previous registration determination exposures, for instance), which is then updated with the registration measurements.

The flow-chart of Fig. 9 illustrates the processing of the various types of position-related data. The determination of displacement vectors and/or a position correction map is done in step 94. The result of this step, the position correction map $\vec{F}(x, y)$, is used to correct the distance measurements and estimated sub-column positions. The distance-measurement system 121 supplies raw measurements $X_1^{raw}, ..., X_N^{raw}$ and $Y_1^{raw}, ..., Y_M^{raw}$ for its $M + N$ beams. Advantageously, these raw measurement values my be low-pass filtered by a filtering sub-unit 91, which is suitably provided as (optional) component of the processing unit 124 of the control unit 120, producing filtered distance measurement values $X_1, ... , X_N, Y_1, ... , Y_M$.

Next, in the distance-measurement fine-adjustment sub-unit 92 of the processing unit 124, the preferably filtered

distance measurements $X_1, \ldots, X_N, Y_1, \ldots, Y_M$ are corrected using the position correction map $\vec{F}(x, y)$ in the column exposure fields which contain sub-columns controlled by the respective measurement (e.g. sub-columns 55, 56 of the embodiment of Fig. 6). This step is performed by calculating, for each distance measurement beam crossing which is aligned with a sub-column, the sub-column coordinates using equation (3) (which is independent of stage yaw due to the small-angle approximation) and subtracting the correction value given by the position correction map at the obtained coordinates from the measurements for the crossing beams, thus obtaining adjusted distance-measurement values $X_1^{adj}, \ldots, X_N^{adj}$ and $Y_1^{adj}, \ldots, Y_M^{adj}$. In the embodiment of Fig. 6, for instance, we have, for $k = 1,2$,

$$X_k^{adj} = X_k - \vec{F}_x\left(x_{D_k}, y_{D_k}\right) = X_k - \vec{F}_x\left(X_{D_k} - X_k, Y_{D_k} - Y_k\right)$$

$$Y_k^{adj} = Y_k - \vec{F}_y\left(x_{D_k}, y_{D_k}\right) = Y_k - \vec{F}_y\left(X_{D_k} - X_k, Y_{D_k} - Y_k\right).$$

If multiple distance-measurement beam crossings are aligned with sub-columns for a single beam, the adjustments can be accordingly averaged. Thus, for instance, in the embodiment of Fig. 5, we have

$$X_n^{adj} = X_n - \frac{1}{3}\sum_{m=1}^{3}\vec{F}_x\left(x_{D_m}, y_{D_n}\right) = X_n - \frac{1}{3}\sum_{m=1}^{3}\vec{F}_x\left(X_{D_m} - X_n, Y_{D_n} - Y_m\right)$$

$$Y_m^{adj} = Y_m - \frac{1}{3}\sum_{n=1}^{3}\vec{F}_x\left(x_{D_m}, y_{D_n}\right) = Y_m - \frac{1}{3}\sum_{n=1}^{3}\vec{F}_x\left(X_{D_m} - X_n, Y_{D_n} - Y_m\right)$$

for $m, n = 1, \ldots, 3$.

Further referring to Fig. 9, using the adjusted distance measurements $X_n^{adj}, Y_m^{adj}$, the column position and orientation calculation sub-unit 93 of the processing unit 124 determines the position $x_C, y_C$ of the distance-measurement system center on the chuck and/or substrate as well as its rotation $\phi$ against the distance-measurement system, e.g. using formula (5) and (6), and transmits these data (i.e., position $x_C, y_C$ and rotation $\phi$) to the stage control unit 125. It is to be noted that, typically, the adjustment of the previous step significantly influences the determined stage position and yaw angle. Additionally, the sub-column positions $x_{S_1}, \ldots, x_{S_J}$ and $y_{S_1}, \ldots, y_{S_J}$ on the chuck (or substrate) may be determined. For sub-columns controlled by a distance-measurement beam crossing (i.e., sub-columns at a reference measurement point of the distance measurement system, such as sub-columns 55, 56 of the embodiment of Fig. 6), the coordinates are determined by way of equation (3), whereas for the other sub-columns (such as sub-columns 53, 54, 58, 59 in Fig. 6) equation (4) may be utilized as explained above.

The sub-column positions as calculated by the above procedure are then transferred to the beam control unit 123. Using these calculated positions as well as the predefined nominal positions of the sub-columns, the beam control unit applies corrections to the sub-column beams, such that the beam images produced on the substrate are shifted from the calculated positions to the desired nominal position on the substate. This is done by means of the individual deflection systems of the sub-columns, for instance by applying / adjusting the control voltages of the respective write multipoles 122.

## Claims

1. A method for controlling a relative positioning of a moveable target and a charged-particle beam array, said charged-particle beam array comprising a plurality of charged-particle beams generated by a plurality of particle-optical columns (109) in a charged-particle multi-beam processing apparatus (1) for exposure of a target (107),

   the target being moved within a target plane through a predetermined sequence of target movement positions, using a target stage (105) of said charged-particle multi-beam processing apparatus (1),
   said plurality of particle-optical columns (109) being arranged along respective longitudinal axes traversing the target plane at respective base points, wherein each particle-optical column (109) is configured to generate and project a respective charged-particle beam onto the target at a respective region around the respective base point for generating, in said region, a pattern portion image in accordance with a pattern to be exposed on the target,

the method comprising

providing said charged-particle multi-beam processing apparatus (1) including said plurality of particle-optical columns;
providing a distance measurement system;
measuring the current position of the target using said distance measurement system; and
performing a repositioning of the charged-particle beams of the particle-optical columns based on the current position of the target,

said distance measurement system being configured for measuring the positions of at least two predefined reference measurement points of the target within the target stage within a measuring plane which is coinciding with or substantially parallel to the target plane,
wherein results of measuring the positions of said reference measurement points are used for calculating an actual position and orientation of the target and deriving a target deviance describing the deviation of the actual target position and orientation from a nominal target movement position and orientation associated therewith,
wherein performing a repositioning of the charged-particle beams of the particle-optical columns based on the current position of the target includes at least one of

controlling the target stage for moving to a corrected position to compensate the target deviance, and
calculating beam displacements for the particle-optical columns within the charged-particle beam array, each of said beam displacements describing a position correction which, with respect to the location of the respective base point of the respective particle-optical column, compensates the target deviance as applied to the respective base point.

2. The method of claim 1, further including a position fine-adjustment procedure with respect to systematic errors of the distance measurement system, comprising

obtaining a position error map, said position error map indicating the position error in the distance measurement system as a function of the respective position,
obtaining, from the distance measurement system, distance-measurement values $(X_1, ..., X_N, Y_1, ..., Y_M)$ along a number of coordinate values,
correcting the distance measurement values using the position error map, to obtain adjusted distance-measurement values ( $X_1^{adj}, ..., X_N^{adj}, Y_1^{adj}, ..., Y_M^{adj}$ ), and
using the adjusted distance-measurement values to determine center data, including a center position $(x_C, y_C)$ and yaw angle $(\phi)$, of the target stage or target.

3. The method of claim 2, the position fine-adjustment procedure further comprising
transmitting the center data to a stage control unit for correction of the position of the target stage or target.

4. The method of claim 2 or 3, wherein the step of obtaining distance-measurement values $(X_1, ..., X_N, Y_1, ..., Y_M)$ along a number of coordinate values is carried out only for a number of pre-determined crossing points, said crossing points having extremal values of the coordinates in the distance measurement system.

5. The method of any one of claims 2 to 4, wherein the position error map used in the position fine-adjustment procedure is determined by

performing an exposure on a test substrate (87) provided with a calibration pattern comprising an array of registration markers (80) and processing said test substrate,
determining the positions of the registration markers,
obtaining positional displacements (82) of the markers by comparison with respective nominal positions (81) of the markers, and
generating the position error map from said positional displacements.

6. The method of claim 5, wherein in the step of performing an exposure on a test substrate (87), the exposure of said registration markers is carried out using said particle-optical columns (109), each particle-optical column (109) using a pattern definition device thereof for defining a pattern portion image to write said registration markers, wherein for the exposure of said registration markers only a center portion of the pattern definition devices is used.

7. The method of any one of the preceding claims, wherein positions of the base points of the particle-optical columns are determined, using an initial calibration process in which:

   a test substrate is exposed using a write process where the particle-optical columns write each a test pattern on said test substrate,
   the positions of the test patterns are measured , and
   the positions thus measured are compared to nominal positions of the respective particle-optical columns and recorded with respect to the differences from said nominal positions,

   wherein preferably the test patterns are copies of a template pattern, said template pattern comprising a pattern figure, such as a cross or star shape, having multiple components radially arranged around a central location.

8. The method of any one of the preceding claims, wherein the reference measurements points respectively are within the geometric projection of a pattern portion image onto the measuring plane, and/or coincide with positions of base points of corresponding particle-optical columns.

9. The method of any one of the preceding claims, wherein calculating the beam displacements includes, for each particle-optical column, measuring a difference between nominal and measured positions for the respective particle-optical column for a plurality of test positions, said plurality of test positions extending over a position range sampling the desired range of motion of the target stage, and determining a deviation of the actual position of the respective base point from a respective nominal position of the respective base point, wherein based on the deviations thus determined a position error map is generated for the deviation between the location of the test positions, said position error map indicating the deviation of position as a function of the position of the nominal base points.

10. The method of claim 9, wherein during performing a writing process involving exposure of the target (107) in said charged-particle multi-beam processing apparatus (1), the results of measuring the positions of reference measurement points are applied to the positions of the particle-optical columns as used for correcting the position of beam images generated on the target by said columns, where the positions of said columns are adjusted using the position error map.

11. The method of any one of the preceding claims, wherein measuring the current position of the target is performed with respect to only said at least two predefined reference measurement points, which correspond to respective base points of particle-optical columns, these particle-optical columns referred to as reference columns, and includes

   determining the actual positions of said reference columns,
   calculating, using actual positions of said reference columns, a position deviance of the entire charged-particle beam array, said position deviance including a yaw angle and positional offset,
   correcting the effect of the position deviance on the charged-particle beam array by repositioning the beam of each of the plurality of particle-optical columns (109) by a position correction suitable to compensate the position deviance as applied to the respective base point of the respective particle-optical column.

12. The method of any one of the preceding claims, wherein said at least two predefined reference measurement points are crossing points which have extremal values of coordinates used in the distance measurement system.

13. The method of any one of the preceding claims, wherein measuring the current position of the target and, if applicable, calculating beam displacement for beams to compensate for deviations of the target current position from a nominal position is performed during a writing process performed on a substrate positioned at the location of the target.
    wherein preferably said measuring the current position of the target and, if applicable, calculating beam displacements is carried out within a total time not exceeding a predetermined delay time, said delay time being preferably 10 μs.

14. The method of any one of the preceding claims, further comprising, for each position in said sequence of target movement positions, referred to as current target position, the steps of

   (i) positioning the target, using the mechanical target stage system, towards the current target position, thus achieving an initial target position which approximates the current target position,
   (ii) measuring the initial target position at positions that correspond to the reference measurement points, to obtain initial target position coordinates,

(iii) calculating, using the initial target position coordinates and coordinates of the reference measurement points, the target deviance, the target deviance including a lateral displacement and a stage yaw angle of the target in the initial target position with respect to the current target position,

(iv) calculating, for each particle-optical column and the respective beam thereof, a beam displacement and a yaw correction which compensates for the difference between the initial target position with respect to the current target position and calculated stage yaw angle for the location of the base point of the respective particle-optical column, and

(v) applying to each beam a correction of the position and orientation of the respective beam image on the target in accordance with the respective beam displacement and yaw correction.

15. The method of any one of the preceding claims, wherein said distance measurement system comprises an interferometer system employing two sets of interferometer beams propagating in said measuring plane, each set having at least two interferometer beams used for performing position measurements along a respective beam direction unique to the respective set, wherein the beam directions of the sets are mutually different, wherein the geometric extensions of interferometer beams of different sets cross at crossing points, at least two of said crossing points being used as reference measurement points for calculating the actual position and orientation of the target.

16. The method of any one of the preceding claims, wherein the particle-optical columns are, within the charged-particle beam array and as regards their respective base points, arranged according to a pre-defined array, within which the particle-optical columns form at least two rows extending parallel to a main direction of movement of the target, said rows being spaced apart by a row offset as measured perpendicular to the main direction.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14a

Fig. 14b

Fig. 14c

Europäisches
Patentamt
European
Patent Office
Office européen
des brevets

# EUROPEAN SEARCH REPORT

**Application Number**

EP 25 17 5370

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 478 395 B1 (MONAHAN KEVIN M [US] ET AL) 25 October 2016 (2016-10-25) | 1-4, 8-13,16 | INV. H01J37/304 |
| Y | * column 1 - column 4; figures 1,2 * <br> * figs. 8, 11 to 13 and related text * <br> * column 11, line 35 - line 64 * <br> * column 14, line 45 - column 16, line 8 * <br> ----- | 5-7 | H01J37/317 |
| X | US 2013/342827 A1 (UMMETHALA UPENDRA [US] ET AL) 26 December 2013 (2013-12-26) | 1-4,8-16 | |
| A | * figs. 6, 9 and related text; paragraphs [0006], [0078] - [0095], [0101], [0119] * <br> ----- | 5-7 | |
| Y | US 2009/039285 A1 (COOPER PATRICK [GB]) 12 February 2009 (2009-02-12) <br> * paragraphs [0008], [0009], [0094] - [0097] * <br> ----- | 5-7 | |
| A | US 6 559 456 B1 (MURAKI MASATO [JP]) 6 May 2003 (2003-05-06) <br> * fig. 12 and related text * <br> ----- | 7 | |

**TECHNICAL FIELDS SEARCHED (IPC)**

H01J

The present search report has been drawn up for all claims

| Place of search | Date of completion of the search | Examiner |
|---|---|---|
| Munich | 15 October 2025 | Krauss, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 5370

This annex lists the patent family members relating to the patent documents cited in the above-mentioned European search report.
The members are as contained in the European Patent Office EDP file on
The European Patent Office is in no way liable for these particulars which are merely given for the purpose of information.

15-10-2025

| Patent document cited in search report | | Publication date | Patent family member(s) | | Publication date |
|---|---|---|---|---|---|
| US 9478395 | B1 | 25-10-2016 | US | 9478395 B1 | 25-10-2016 |
| | | | US | 9595419 B1 | 14-03-2017 |
| | | | US | 10020166 B1 | 10-07-2018 |
| US 2013342827 | A1 | 26-12-2013 | EP | 2859577 A1 | 15-04-2015 |
| | | | JP | 6328106 B2 | 23-05-2018 |
| | | | JP | 2015522950 A | 06-08-2015 |
| | | | TW | 201411680 A | 16-03-2014 |
| | | | US | 2013342827 A1 | 26-12-2013 |
| | | | WO | 2013188547 A1 | 19-12-2013 |
| US 2009039285 | A1 | 12-02-2009 | EP | 2003526 A1 | 17-12-2008 |
| | | | JP | 2009026300 A | 05-02-2009 |
| | | | US | 2009039285 A1 | 12-02-2009 |
| US 6559456 | B1 | 06-05-2003 | US | 6559456 B1 | 06-05-2003 |
| | | | US | 2003107006 A1 | 12-06-2003 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9053906 B
- US 9520268 B
- US 6768125 B
- US 8222621 B
- US 8378320 B
- US 7214951 B
- US 9443699 B2
- US 20230015805 A1
- US 9443699 B
- US 9495499 B